# EUROPÄISCHE PATENTANMELDUNG

(11) **EP 4 312 263 A1**
(43) Veröffentlichungstag der Anmeldung: **31.01.2024**
(21) Anmeldenummer: 22187838.2
(22) Anmeldetag: 29.07.2022
(51) Int. Cl.: H01L 23/49, H01L 25/07, G06F 30/367, H01L 23/498

(54) **HALBLEITERANORDNUNG MIT EINEM HALBLEITERELEMENT, EINEM SUBSTRAT UND ZUMINDEST EINEM VERDRAHTUNGSELEMENT**

(71) Anmelder: Siemens Aktiengesellschaft, 80333 München (DE)
(72) Erfinder: Käsbauer, Michael, 90425 Nürnberg (DE); Maier, Lukas, 91077 Kleinsendelbach (DE); Roppelt, Bernd, 96173 Unterhaid (DE); Schmenger, Jens, 91301 Forchheim (DE)
(74) Vertreter: Siemens Patent Attorneys

(57) **Zusammenfassung**

Die Erfindung betrifft ein Halbleiteranordnung (2) mit einem Halbleiterelement (4), einem Substrat (6) und zumindest einem Verdrahtungselement (22). Um eine verbesserte Zuverlässigkeit zu erreichen, wird vorgeschlagen, dass das Substrat (6) eine Substratmetallisierung (14) mit voneinander elektrisch isoliert angeordneten Leitungsabschnitten (12, 16, 18) aufweist, wobei das Halbleiterelement (4), insbesondere stoffschlüssig, mit einem ersten Leitungsabschnitt (12) der Substratmetallisierung (14) verbunden ist, wobei das Halbleiterelement (4) auf einer dem Substrat (6) abgewandten Seite eine Kontaktfläche (8) aufweist, wobei die Kontaktfläche (8) des Halbleiterelements (4) über zumindest ein Verdrahtungselement (22) mit dem Substrat (6) verbunden ist, wobei das zumindest eine Verdrahtungselement (22) einen ersten Verbindungsabschnitt (24), welcher die Kontaktfläche (8) mit einem zweiten Leitungsabschnitt (16) der Substratmetallisierung (14) verbindet, und einen zweiten Verbindungsabschnitt (26), welcher die Kontaktfläche (8) mit einem dritten Leitungsabschnitt (18) der Substratmetallisierung (14) verbindet, aufweist, wobei der zweite und der dritten Leitungsabschnitt (16, 18) der Substratmetallisierung (14) konfiguriert sind, dass der erste Verbindungsabschnitt (24) und der zweite Verbindungsabschnitt (26) während eines Betriebes der Halbleiteranordnung (2) einen unsymmetrischen Stromfluss aufweisen.

## Beschreibung

Die Erfindung betrifft eine Halbleiteranordnung mit einem Halbleiterelement, einem Substrat und zumindest einem Verdrahtungselement.

Ferner betrifft die Erfindung einen Stromrichter mit mindestens einer derartigen Halbleiteranordnung.

Überdies betrifft die Erfindung ein Verfahren zur Herstellung einer derartigen Halbleiteranordnung, wobei das Halbleiterelement, insbesondere stoffschlüssig, auf dem Substrat verbunden wird, wobei in einem weiteren Schritt die Kontaktfläche des Halbleiterelements über das zumindest eine Verdrahtungselement mit dem Substrat verbunden wird.

Darüber hinaus betrifft die Erfindung ein Computerprogrammprodukt, umfassend Befehle, die bei einer Ausführung des Programms durch einen Computer diesen veranlassen, ein Verhalten einer derartigen Halbleiteranordnung zu simulieren.

Ein derartiges Halbleitermodul kommt in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Die im Halbleitermodul zum Einsatz kommenden Halbleiterelemente sind unter anderem Transistoren, Triacs, Thyristoren oder Dioden. Transistoren sind beispielsweise als Insulated-Gate-BipolarTransistoren (IGBTs), Feldeffekttransistoren oder Bipolartransistoren ausgeführt. Die Halbleiterelemente einer Halbleiteranordnung sind üblicherweise über Verdrahtungselemente auf einem Substrat kontaktiert. Derartige Verdrahtungselemente können unter anderem Bonddrähte und/oder Bondbänder umfassen. Insbesondere Lastkontakte eines Halbleiterelements, unter anderem ein Emitter-Kontakt eines IGBTs, sind üblicherweise mit einer Mehrzahl von Verdrahtungselementen auf dem Substrat kontaktiert.

Die Offenlegungsschrift DE 11 2019 000 660 T5 beschreibt eine Halbleitervorrichtung, die Folgendes umfasst: ein Substrat, das eine Hauptoberfläche besitzt; mehrere Leitermuster, die auf der Hauptoberfläche vorgesehen sind; mehrere Schaltelemente, die auf den mehreren Leitermustern angeordnet sind, um Kollektor-Elektroden zu verbinden; und ein einzelnes oder mehrere Verdrahtungselemente, die Emitter-Elektroden der Schaltelemente, die auf verschiedenen Leitermustern angeordnet und zwischen den mehreren Schaltelementen parallelgeschaltet sind, direkt verbinden.

Während des Betriebes der Halbleiterelemente können sich Verdrahtungselemente vom Lastkontakt ablösen, was zu einem Ausfall der Halbleiteranordnung führt. Eine robustere Verdrahtung führt zu einer verbesserten Zuverlässigkeit der Halbleiteranordnung.

Vor diesem Hintergrund besteht die Aufgabe der vorliegenden Erfindung darin, eine Halbleiteranordnung anzugeben, welche eine verbesserte Zuverlässigkeit aufweist.

Die Aufgabe wird erfindungsgemäß gelöst durch eine Halbleiteranordnung mit einem Halbleiterelement, einem Substrat und zumindest einem Verdrahtungselement, wobei das Substrat eine Substratmetallisierung mit voneinander elektrisch isoliert angeordneten Leitungsabschnitten aufweist, wobei das Halbleiterelement, insbesondere stoffschlüssig, mit einem ersten Leitungsabschnitt der Substratmetallisierung verbunden ist, wobei das Halbleiterelement auf einer dem Substrat abgewandten Seite eine Kontaktfläche aufweist, wobei die Kontaktfläche des Halbleiterelements über zumindest ein Verdrahtungselement mit dem Substrat verbunden ist, wobei das zumindest eine Verdrahtungselement einen ersten Verbindungsabschnitt, welcher die Kontaktfläche mit einem zweiten Leitungsabschnitt der Substratmetallisierung verbindet, und einen zweiten Verbindungsabschnitt, welcher die Kontaktfläche mit einem dritten Leitungsabschnitt der Substratmetallisierung verbindet, aufweist, wobei der zweite und der dritten Leitungsabschnitt der Substratmetallisierung konfiguriert sind, dass der erste Verbindungsabschnitt und der zweite Verbindungsabschnitt während eines Betriebes der Halbleiteranordnung einen unsymmetrischen Stromfluss aufweisen.

Ferner wird die Aufgabe erfindungsgemäß gelöst durch einen Stromrichter mit mindestens einer derartigen Halbleiteranordnung.

Überdies wird die Aufgabe erfindungsgemäß gelöst durch ein Verfahren zur Herstellung einer derartigen Halbleiteranordnung, wobei das Halbleiterelement, insbesondere stoffschlüssig, auf dem Substrat verbunden wird, wobei in einem weiteren Schritt die Kontaktfläche des Halbleiterelements über das zumindest eine Verdrahtungselement mit dem Substrat verbunden wird.

Darüber hinaus wird die Aufgabe erfindungsgemäß gelöst durch ein Computerprogrammprodukt, umfassend Befehle, die bei einer Ausführung des Programms durch einen Computer diesen veranlassen, ein, insbesondere thermisches, mechanisches und/oder elektrisches, Verhalten einer derartigen Halbleiteranordnung zu simulieren.

Die in Bezug auf die Halbleiteranordnung nachstehend angeführten Vorteile und bevorzugten Ausgestaltungen lassen sich sinngemäß auf den Stromrichter, das Verfahren und das Computerprogrammprodukt übertragen.

Der Erfindung liegt die Überlegung zugrunde, die Zuverlässigkeit einer Halbleiteranordnung dadurch zu verbessern, dass die Wahrscheinlichkeit für einen Ausfall während des Betriebes der Halbleiteranordnung durch von einem Halbleiterelement abgelöste Verdrahtungselemente signifikant verringert wird. Eine derartige Halbleiteranordnung weist ein Substrat mit einer Substratmetallisierung auf. Das Substratmetallisierung ist strukturiert ausgeführt, das heißt sie weist voneinander elektrisch isoliert angeordnete Leitungsabschnitte auf. Das Halbleiterelement ist, insbesondere stoffschlüssig, mit einem ersten Leitungsabschnitt der Substratmetallisierung verbunden. Die stoffschlüssige Verbindung wird beispielsweise durch Löten, Sintern oder Adhäsion hergestellt. Ferner weist das Halbleiterelement auf einer dem Substrat abgewandten Seite eine Kontaktfläche auf, welche über zumindest ein Verdrahtungselement mit dem Substrat verbunden ist. Beispielsweise ist das Halbleiterelement als IGBT ausgeführt, der kollektorseitig auf den ersten Leitungsabschnitt der Substratmetallisierung gelötet oder gesintert ist, während er emitterseitig über das zumindest eine Verdrahtungselement mit dem Substrat verbunden ist. Das zumindest eine Verdrahtungselement ist beispielsweise als Bonddraht oder Bondband ausgeführt, wobei durch Ultraschall-Bondverbindungen die Verbindung zwischen dem Substrat und der Kontaktfläche des Halbleiterelements herstellbar ist. Das zumindest eine Verdrahtungselement umfasst einen ersten Verbindungsabschnitt, der eine Verbindung der Kontaktfläche mit einem zweiten Leitungsabschnitt der Substratmetallisierung herstellt. Fließt Strom, insbesondere Laststrom, durch das zumindest eine Verdrahtungselement, wirkt eine Scherkraft auf Verbindungen, insbesondere Ultraschall-Bondverbindungen, zwischen der Kontaktfläche des Halbleiterelements und dem Verdrahtungselement.

Um einer derartigen Scherkraft entgegenzuwirken, umfasst das zumindest eine Verdrahtungselement einen zweiten Verbindungsabschnitt, der die Kontaktfläche mit einem dritten Leitungsabschnitt der Substratmetallisierung verbindet, wobei der erste Leitungsabschnitt, der zweite Leitungsabschnitt und der dritte Leitungsabschnitt elektrisch voneinander isoliert auf dem Substrats angeordnet sind. Der zweite und der dritte Leitungsabschnitt der Substratmetallisierung sind konfiguriert, dass der erste Verbindungsabschnitt und der zweite Verbindungsabschnitt des zumindest einen Verdrahtungselements während eines Betriebes der Halbleiteranordnung einen unsymmetrischen Stromfluss aufweisen. Dies ist unter anderem der Fall, wenn der zweite oder der dritte Leitungsabschnitt, abgesehen von der Verbindung mit dem zumindest einen Verdrahtungselement, floatend angeordnet ist, sodass ein Strom von der Halbleiteranordnung zumindest überwiegend, insbesondere im Wesentlichen ausschließlich, über den ersten oder zweiten Verbindungsabschnitt des zumindest einen Verdrahtungselements fließt. Durch die zusätzliche Verbindung des zumindest einen Verdrahtungselements über den zweiten Verbindungsabschnitt mit dem dritten Leitungsabschnitt, was auch "Überbonden" genannt wird, wirkt eine Gegenkraft der Scherkraft entgegen, sodass die Verbindungen des zumindest einen Verdrahtungselements mit der Kontaktfläche, insbesondere unter Last, robuster sind, was sich positiv auf die Zuverlässigkeit der Halbleiteranordnung auswirkt und dessen Lebensdauer verlängert.

Ein Computerprogrammprodukt, welches Befehle umfasst, die bei einer Ausführung des Programms durch einen Computer diesen veranlassen, ein, insbesondere thermisches, mechanisches und oder elektrisches, Verhalten der beschriebenen Halbleiteranordnung zu simulieren kann einen "digitalen Zwilling", auch "digital twin" genannt, umfassen oder als ein solcher ausgebildet sein. Ein derartiger digitaler Zwilling ist beispielsweise in der Offenlegungsschrift US 2017/0286572 A1 dargestellt. Der Offenbarungsgehalt von US 2017/0286572 A1 wird durch Verweisung in die vorliegende Anmeldung mit einbezogen. Der "digitale Zwilling" ist beispielsweise eine digitale Repräsentanz der für den Betrieb der Halbleiteranordnung relevanten Komponenten.

Eine weitere Ausführungsform sieht vor, dass der zweite und der dritte Leitungsabschnitt der Substratmetallisierung auf gegenüberliegenden Seiten des Halbleiterelements angeordnet sind. Durch die gegenüberliegende Anordnung kann die Gegenkraft der Scherkraft parallel verlaufend entgegenwirken, sodass eine optimale Robustheit erzielbar ist.

Eine weitere Ausführungsform sieht vor, dass ein durch den ersten Verbindungsabschnitt des zumindest einen Verdrahtungselements fließender erster Strom, insbesondere Laststrom, um das Hundertfache, insbesondere um das Tausendfache größer ist als ein durch den zweiten Verbindungsabschnitt des zumindest einen Verdrahtungselements fließender zweiter Strom. Dies ist unter anderem der Fall, wenn der dritte Leitungsabschnitt, abgesehen von der Verbindung mit dem zumindest einen Verdrahtungselement, floatend angeordnet ist, während der zweite Leitungsabschnitt beispielsweise mit einem AC- oder DC-Anschluss verbunden ist. Auf diese Weise wird, insbesondere unter Last, eine optimale Robustheit der Verbindungen des zumindest einen Verdrahtungselements mit der Kontaktfläche erzielt.

Eine weitere Ausführungsform sieht vor, dass der mit dem zweiten Verbindungsabschnitt des zumindest einen Verdrahtungselements verbundene dritte Leitungsabschnitt leerlaufend auf dem Substrat angeordnet ist. Eine leerlaufende Anordnung des dritten Leitungsabschnitts bedeutet, dass dieser neben dem zumindest einen Verdrahtungselement mit keiner weiteren Komponente elektrisch leitend verbunden ist. Auf diese Weise wird, insbesondere unter Last, eine optimale Robustheit der Verbindungen des zumindest einen Verdrahtungselements mit der Kontaktfläche erzielt.

Eine weitere Ausführungsform sieht vor, dass der erste Verbindungsabschnitt und der zweite Verbindungsabschnitt des zumindest einen Verdrahtungselements im Wesentlichen achsensymmetrisch bezüglich einer Symmetrieachse ausgeführt sind. Durch eine im Wesentlichen achsensymmetrische Anordnung werden auftretende Scherkräfte durch den Scherkräften entgegenwirkende Gegenkräfte optimal ausgeglichen.

Eine weitere Ausführungsform sieht vor, dass das zumindest eine Verdrahtungselement einen dritten Verbindungsabschnitt aufweist, welcher den dritten Leitungsabschnitt der Substratmetallisierung mit einer Kontaktfläche eines weiteren Halbleiterelements verbindet. Beispielsweise ist das Halbleiterelement als IGBT ausgeführt, während das weitere Halbleiterelement als eine antiparallel zum Halbleiterelement geschaltete Diode ausgeführt ist. Alternativ kann das weitere Halbleiterelement unter anderem als ein weiterer parallel zum als IGBT ausgeführten Halbleiterelement geschalteter weiterer IGBT ausgeführt sein. Durch eine derartige Anordnung wird eine verbesserte Robustheit der Verbindungen des zumindest einen Verdrahtungselements mit den Kontaktflächen der Halbleiterelemente erzielt, was sich positiv auf die Zuverlässigkeit der Halbleiteranordnung auswirkt und dessen Lebensdauer verlängert.

Eine weitere Ausführungsform sieht vor, dass die Halbleiteranordnung eine Mehrzahl von Verdrahtungselementen zur Verbindung der Kontaktfläche mit dem zweiten und dem dritten Leitungsabschnitt umfasst. Insbesondere für höhere Lastströme ist eine derartige Ausgestaltung vorteilhaft. Ferner werden durch eine Parallelschaltung von Verdrahtungselementen parasitäre Induktivitäten verringert, was zu geringeren Schaltverlusten führt.

Eine weitere Ausführungsform sieht vor, dass das Halbleiterelement auf einer dem dritten Leitungsabschnitt zugewandten Seite breiter ausgeführt ist als der dritte Leitungsabschnitt, wobei ein Hauptstrompfad des ersten Leitungsabschnitts beidseitig an dem dritten Leitungsabschnitt vorbei verlaufend ausgebildet ist. Beispielsweise fließt über den ersten Leitungsabschnitt ein Laststrom zum Halbleiterelement. In diesem Fall wird ein Hauptstrompfad des Laststroms beidseitig am dritten Leitungsabschnitt vorbei. Durch eine schmälere Ausgestaltung des dritte Leitungsabschnitts wird eine verbesserte Stromführung erreicht, was beispielsweise zu geringeren Verlusten führt.

Eine weitere Ausführungsform sieht vor, dass der Hauptstrompfad des ersten Leitungsabschnitts im Wesentlichen symmetrisch an dem dritten Leitungsabschnitt vorbei verlaufend ausgebildet ist. Durch eine derartige Ausgestaltung der Anordnung wird eine optimierte Stromführung erreicht.

Eine weitere Ausführungsform sieht vor, dass mehr Verdrahtungselemente mit dem zweiten Leitungsabschnitt als mit dem dritten Leitungsabschnitt verbunden sind. Beispielsweise weist zumindest ein Verdrahtungselement, insbesondere mindestens ein äußeres Verdrahtungselement, keinen zweiten Verbindungsabschnitt zur Verbindung mit dem dritten Leitungsabschnitt auf, wodurch eine schmälere Ausgestaltung des dritte Leitungsabschnitts ermöglicht wird, was zu einer verbesserten Stromführung führt.

Eine weitere Ausführungsform sieht vor, dass der dritte Leitungsabschnitt der Substratmetallisierung mindestens zwei voneinander elektrisch isoliert angeordnete Verdrahtungsinseln umfasst, welche leerlaufend auf dem Substrat angeordnet sind, wobei jeweils zumindest ein Verdrahtungselement über den jeweiligen zweiten Verbindungsabschnitt mit einer der Verdrahtungsinseln des dritten Leitungsabschnitts verbunden ist. Eine derartige geteilte Anordnung ermöglicht eine verbesserte Stromführung, was beispielsweise zu geringeren Verlusten führt.

Eine weitere Ausführungsform sieht vor, dass zwei Verdrahtungsinseln derartig auf dem Substrat angeordnet sind, dass zwischen den Verdrahtungsinseln ein Hauptstrompfad verlaufend ausgebildet ist. Beispielsweise fließt zwischen den Verdrahtungsinseln ein Laststrom zum Halbleiterelement. Durch eine derartige direkte Stromführung werden Verluste reduziert.

Eine weitere Ausführungsform sieht vor, dass das Halbleiterelement als schaltbares Halbleiterelement, insbesondere als Transistor, ausgebildet ist und mit zumindest einem weiteren schaltbaren Halbleiterelement eine Halbbrücke ausbildet. Beispielsweise ist das Halbleiterelement als Low Side Schalter der Halbbrücke konfiguriert. Insbesondere sind das schaltbare Halbleiterelement und das weitere schaltbare Halbleiterelement jeweils als zumindest ein IGBT ausgeführt. Aufgrund der Schaltungstopologie der Halbbrücke kann es beispielsweise dazu kommen, dass die Verdrahtung des Low Side Schalters eine geringere Zuverlässigkeit aufweist, was die Lebensdauer der Halbbrücke negativ beeinflusst. In diesem Beispiel wird durch das Überbonden der Verdrahtungselemente über den zweiten Verbindungsabschnitt auf den dritten Leitungsabschnitt die Zuverlässigkeit des Low Side Schalters verbessert bzw. angepasst, sodass eine höhere Lebensdauer der Halbbrücke erreicht wird.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausführungsform einer Halbleiteranordnung in einer Draufsicht,
- FIG 2: eine schematische Darstellung der ersten Ausführungsform der Halbleiteranordnung in einer Querschnittsdarstellung,
- FIG 3: eine schematische Darstellung einer zweiten Ausführungsform einer Halbleiteranordnung in einer Draufsicht,
- FIG 4: eine schematische Darstellung einer dritten Ausführungsform einer Halbleiteranordnung in einer Draufsicht,
- FIG 5: eine schematische Darstellung einer vierten Ausführungsform einer Halbleiteranordnung in einer Draufsicht,
- FIG 6: eine schematische Darstellung einer fünften Ausführungsform einer Halbleiteranordnung in einer Draufsicht,
- FIG 7: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

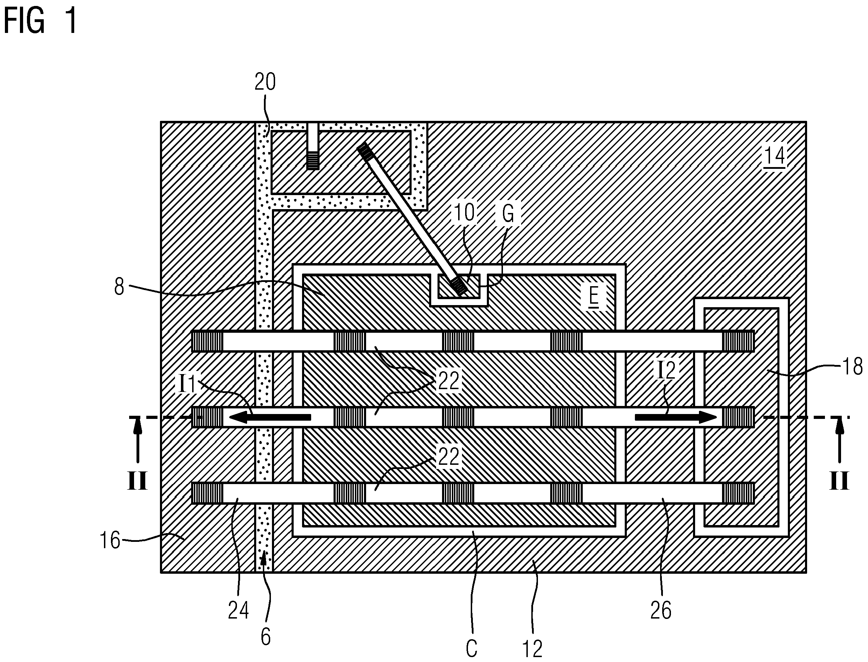

FIG 1 zeigt eine schematische Darstellung einer ersten Ausführungsform einer Halbleiteranordnung 2 in einer Draufsicht, welche ein Halbleiterelement 4 umfasst, das auf einem Substrat 6 kontaktiert ist. Beispielhaft ist das Halbleiterelement 4 als ein Insulated-Gate-Bipolar-Transistor (IGBT) ausgeführt. Weitere Beispiele für derartige Halbleiterelemente 4 sind Triacs, Thyristoren, Dioden oder andere Transistortypen wie Feldeffekttransistoren oder Biploartransistoren. Der IGBT umfasst einen Steueranschluss, welcher als Gate-Anschluss G ausgeführt ist, sowie Lastanschlüsse, welche als Kollektor-Anschluss C und Emitter-Anschluss E ausgeführt sind, wobei der Kollektor-Anschluss C, auf einer dem Substrat 6 zugewandten Seite des Halbleiterelements 4 stoffschlüssig, mit dem Substrat 6 verbunden ist.

Der Emitter-Anschluss E weist eine Kontaktfläche 8 auf, wobei der Gate-Anschluss G eine von der Kontaktfläche 8 des Emitter-Anschlusses E elektrisch isoliert angeordnete Steuerkontaktfläche 10 aufweist. Die Kontaktfläche 8 und die Steuerkontaktfläche 10 weisen zumindest eine metallische Schicht auf, welche beispielsweise Aluminium, Kupfer und/oder Gold enthält. Der IGBT ist, beispielsweise über eine Löt- oder Sinterverbindung, mit einem ersten Leitungsabschnitt 12 einer Substratmetallisierung 14 des Substrats 6 verbunden. Ferner weist das Substrat 6 einen von dem ersten Leitungsabschnitt 12 elektrisch isoliert angeordneten zweiten Leitungsabschnitt 16 und einen inselartig im ersten Leitungsabschnitt 12 ausgebildeten und von diesem elektrisch isolierten dritten Leitungsabschnitt 18 auf, wobei der zweite und der dritte Leitungsabschnitt 16, 18 der Substratmetallisierung 14 auf gegenüberliegenden Seiten des Halbleiterelements 4 angeordnet sind. Darüber hinaus umfasst das Substrat 6 eine dielektrische Materiallage 20, die beispielsweise einen keramischen Werkstoff, insbesondere Aluminiumnitrid oder Aluminiumoxid, enthält und eine Stärke von 25 µm bis 400 µm, insbesondere 50 µm bis 250 µm, aufweist.

Überdies weist die Halbleiteranordnung 2 eine Mehrzahl von Verdrahtungselementen 22 zur Verbindung der Kontaktfläche 8 des Emitter-Anschlusses E mit dem zweiten und dem dritten Leitungsabschnitt 16, 18 auf. Die Verdrahtungselemente 22 sind als im Wesentlichen parallel verlaufende Bonddrähte oder Bondbänder, welche beispielsweise Aluminium, Kupfer und/oder Gold enthalten, ausgeführt. Darüber hinaus weisen die Verdrahtungselemente 22 jeweils einen ersten Verbindungsabschnitt 24, welcher die Kontaktfläche 8 des Emitter-Anschlusses E mit dem zweiten Leitungsabschnitt 16 der Substratmetallisierung 14 verbindet, und einen zweiten Verbindungsabschnitt 26, welcher die Kontaktfläche 8 des Emitter-Anschlusses E mit dem dritten Leitungsabschnitt 18 der Substratmetallisierung 14 verbindet, auf. Der mit dem zweiten Verbindungsabschnitt 26 des jeweiligen Verdrahtungselement 22 verbundene dritte Leitungsabschnitt 18 ist leerlaufend auf dem Substrat 6 angeordnet. Die leerlaufende Anordnung hat zur Folge, dass während eines Betriebes der Halbleiteranordnung 2, ein erster Strom I1, insbesondere ein Laststrom, vom Emitter E über die ersten Verbindungsabschnitte 24 der jeweiligen Verdrahtungselementen 22 fließt, während ein, insbesondere vernachlässigbar kleiner, zweiter Strom I2 über die zweiten Verbindungsabschnitte 26 fließt. Insbesondere ist der erste Strom I1 um das Hundertfache, insbesondere um das Tausendfache größer als der zweite Strom I2. Somit weisen der erste Verbindungsabschnitt 24 und der zweite Verbindungsabschnitt 26 während des Betriebes der Halbleiteranordnung 2 einen unsymmetrischen Stromfluss auf.

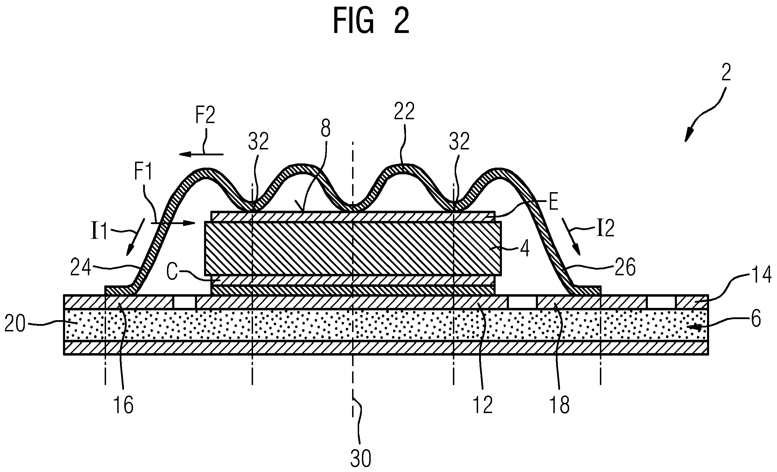

FIG 2 zeigt eine schematische Darstellung der ersten Ausführungsform der Halbleiteranordnung 2 in einer Querschnittsdarstellung. Die Verdrahtungselemente 22 sind als Bonddrähte ausgeführt und bilden auf der Kontaktfläche 8 zwischen dem ersten Verbindungsabschnitt 24 und dem zweiten Verbindungsabschnitt 26 eine Mehrzahl von Stitchkontakten 32 aus, wobei die Verbindung mittels Ultraschall-Bonden hergestellt ist. Die Verbindung der Verdrahtungselemente 22 zur Kontaktfläche 8 des Halbleiterelements 4 wird mittels Durchschleifen der Verdrahtungselemente 22, insbesondere mittels Multi-Stitch Wedge-to-Wedge-Wirebonding, hergestellt. Das mehrfache Bonden wird auch "Stitchen" genannt. Üblicherweise werden derartige Stitchkontakte 32 auch als "Stitchbonds" bezeichnet und können z.B. als "Wedgebonds" ausgeführt sein. Der erste Verbindungsabschnitt 24 und der zweite Verbindungsabschnitt 26 der jeweiligen Verdrahtungselemente 22 sind im Wesentlichen achsensymmetrisch bezüglich einer Symmetrieachse 30 ausgeführt.

Fließt ein erster Strom I1, insbesondere Laststrom, über die Verdrahtungselemente 22, wirkt eine Scherkraft F1 auf die Verbindungen 32, insbesondere Ultraschall-Bondverbindungen. Infolge des Überbondens der Verdrahtungselemente 22 über den zweiten Verbindungsabschnitt 26 auf den dritten Leitungsabschnitt 18 kann eine Gegenkraft F2 der Scherkraft F1 entgegenwirken, sodass die Verbindungen 32, insbesondere unter Last, robuster sind. Die Folge ist, dass durch das Überbonden eine längere Lebensdauer der Halbleiteranordnung 2 erzielt wird.

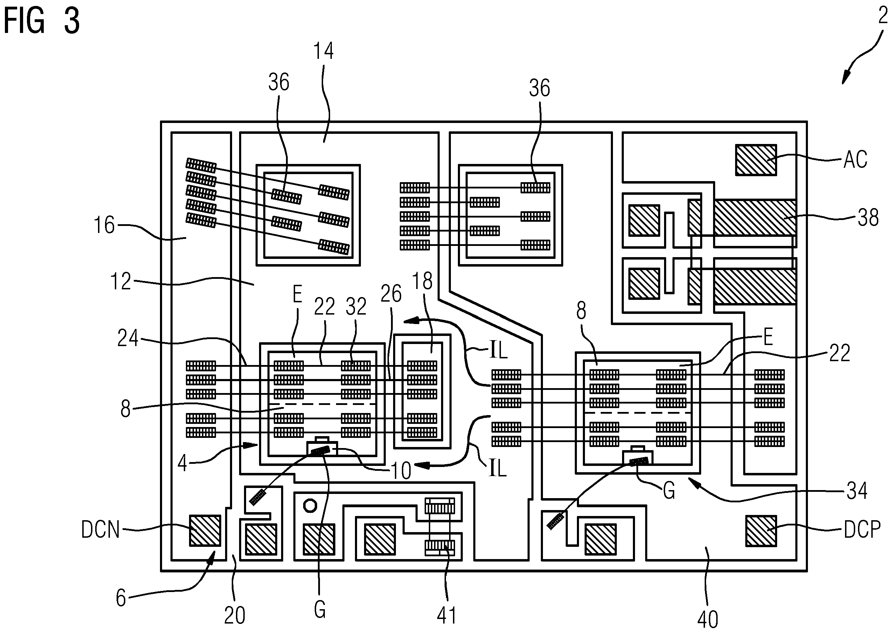

FIG 3 zeigt eine schematische Darstellung einer zweiten Ausführungsform einer Halbleiteranordnung 2 in einer Draufsicht, wobei mit dem als IGBT ausgeführten Halbleiterelement 4 und einem weiteren Halbleiterelement 34, das ebenfalls als IGBT ausgeführt ist, eine Halbbrücke ausbildet ist. Die Halbleiterelemente 4, 34 weisen jeweils eine antiparallel geschaltete Diode 36 auf.

Das Halbleiterelement 4 ist als Low Side Schalter der Halbbrücke konfiguriert. Der erster Leitungsabschnitt 12 des Substrats 6 ist über einen Shunt-Widerstand 38 mit einem AC-Anschluss AC verbunden, während der zweite Leitungsabschnitt 16 mit einem negativen DC-Anschluss DCN der Halbbrücke verbunden ist. Das weitere Halbleiterelement 34 ist, insbesondere stoffschlüssig, mit einem vierten Leitungsabschnitt 40 der Substratmetallisierung 14 verbunden, wobei der vierte Leitungsabschnitt 40 mit einem positiven DC-Anschluss DCP der Halbbrücke verbunden ist. Ein Laststrompfad IL des ersten Leitungsabschnitts 12 ist beidseitig an dem dritten Leitungsabschnitt 18 vorbei verlaufend ausgebildet. Ferner umfasst die Halbleiteranordnung 2 einen Temperatursensor, der beispielsweise als ein NTC-Thermistor (Negative Temperature Coefficient Thermistor) ausgeführt ist. Die weitere Ausgestaltung der Halbleiteranordnung 2 in FIG 3 entspricht der in FIG 1 bzw. FIG 2.

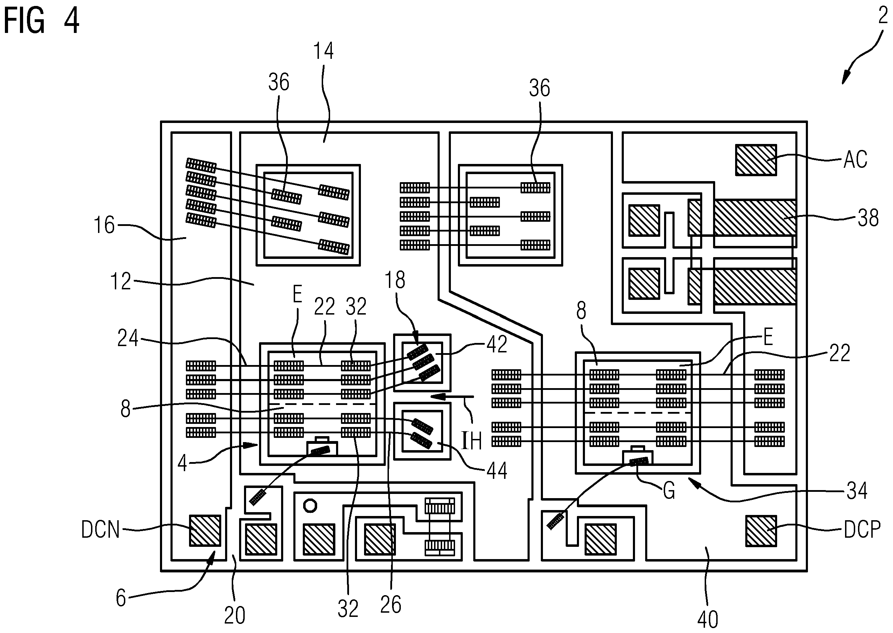

FIG 4 zeigt eine schematische Darstellung einer dritten Ausführungsform einer Halbleiteranordnung 2 in einer Draufsicht. Der dritte Leitungsabschnitt 18 der Substratmetallisierung 14 weist zwei voneinander elektrisch isoliert angeordnete Verdrahtungsinseln 42, 44 auf, welche jeweils leerlaufend auf dem Substrat 6 angeordnet sind. Die zweiten Verbindungsabschnitte 26 der Verdrahtungselemente 22 sind jeweils mit einer der Verdrahtungsinseln 42, 44 des dritten Leitungsabschnitts 18 verbunden. Beispielhaft sind drei Verdrahtungselemente 22 mit einer erste Verdrahtungsinsel 42 und zwei Verdrahtungselemente 22 mit einer zweiten Verdrahtungsinsel 44 verbunden. Die beispielhaft rechteckigen Verdrahtungsinseln 42, 44 sind derartig auf dem Substrat 6 beabstandet angeordnet, dass dazwischen ein Hauptstrompfad IH zwischen den Halbleiterelementen 4, 34 ausgebildet wird. Die weitere Ausgestaltung der Halbleiteranordnung 2 in FIG 4 entspricht der in FIG 3.

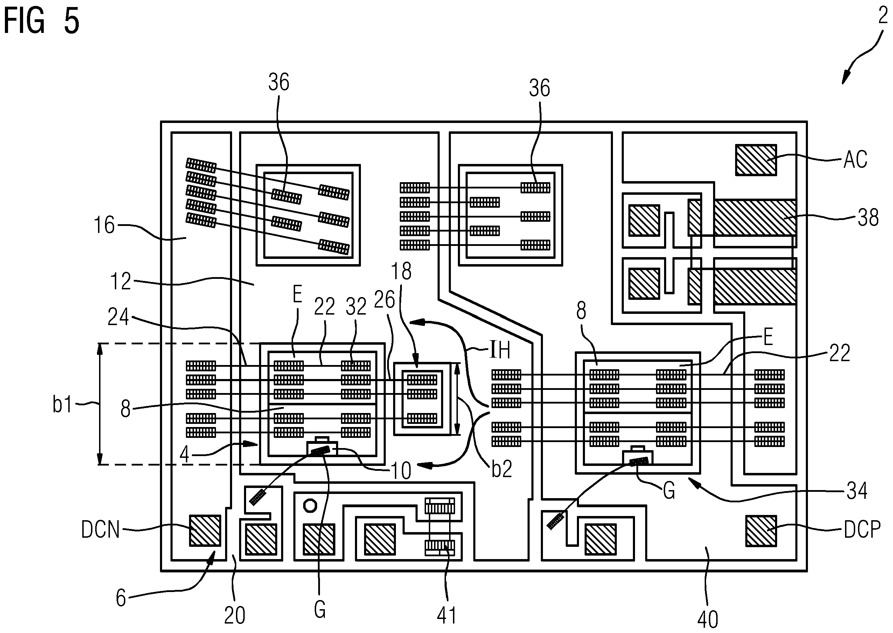

FIG 5 zeigt eine schematische Darstellung einer vierten Ausführungsform einer Halbleiteranordnung 2 in einer Draufsicht, wobei nur drei der insgesamt beispielhaft fünf Verdrahtungselemente 22 zur Verbindung der Kontaktfläche 8 des Halbleiterelements 4 mit dem Substrat 6 über einen zweiten Verbindungsabschnitt 26 mit dem dritten Leitungsabschnitt 18 verbunden sind. Das Halbleiterelement 4 weist auf einer dem dritten Leitungsabschnitt 18 zugewandten Seite eine erste Breite b1 auf, während der dritte Leitungsabschnitt 18 eine zweite Breite b2 aufweist, welche kleiner als die erste Breite b1 ist. Ein Hauptstrompfad IH des ersten Leitungsabschnitts 12 ist im Wesentlichen symmetrisch und beidseitig an dem dritten Leitungsabschnitt 18 vorbei verlaufend ausgebildet. Die weitere Ausgestaltung der Halbleiteranordnung 2 in FIG 5 entspricht der in FIG 3.

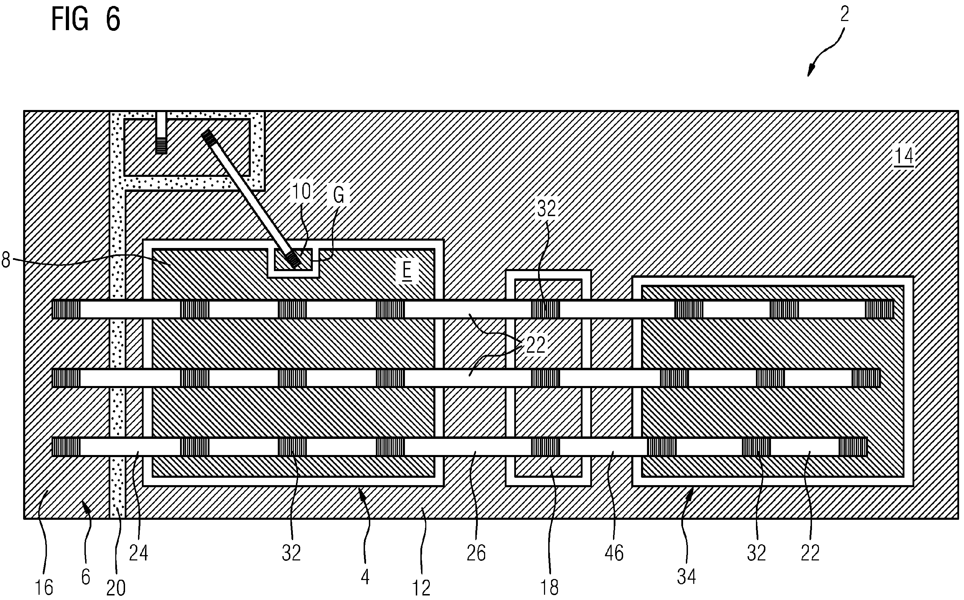

FIG 6 zeigt eine schematische Darstellung einer fünften Ausführungsform einer Halbleiteranordnung 2 in einer Draufsicht, wobei ein weiteres Halbleiterelement 34 über die Verdrahtungselemente 22, welche zur Verbindung der Kontaktfläche 8 des Halbleiterelements 4, welches beispielhaft als IGBT ausgeführt ist, mit dem zweiten und dritten Leitungsabschnitt 16, 18 vorgesehen sind, verbunden sind. Die Verdrahtungselemente 22 weisen einen dritten Verbindungsabschnitt 46 auf, welcher den dritten Leitungsabschnitt 18 der Substratmetallisierung 14 mit dem weiteren Halbleiterelement 34 verbindet. Das weitere Halbleiterelement 34 ist beispielhaft als eine antiparallel zum Halbleiterelement 4 geschaltete Diode ausgeführt. Zusätzlich oder alternativ kann das weitere Halbleiterelement 34 zumindest einen weiteren parallel zum Halbleiterelement 4 geschalteten IGBT umfassen. Der dritte Leitungsabschnitt 18 ist leerlaufend ausgeführt, das heißt der dritte Leitungsabschnitt 18 ist neben den Verdrahtungselementen 22 mit keiner weiteren Komponente elektrisch leitend verbunden. Die weitere Ausgestaltung der Halbleiteranordnung 2 in FIG 6 entspricht der in FIG 1 bzw. FIG 2.

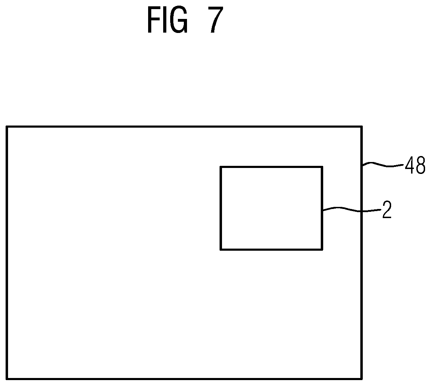

FIG 7 zeigt eine schematische Darstellung eines Stromrichters 48, welcher beispielhaft eine Halbleiteranordnung 2 umfasst.

## Patentansprüche

1. Halbleiteranordnung (2) mit einem Halbleiterelement (4), einem Substrat (6) und zumindest einem Verdrahtungselement (22),
wobei das Substrat (6) eine Substratmetallisierung (14) mit voneinander elektrisch isoliert angeordneten Leitungsabschnitten (12, 16, 18) aufweist,
wobei das Halbleiterelement (4), insbesondere stoffschlüssig, mit einem ersten Leitungsabschnitt (12) der Substratmetallisierung (14) verbunden ist,
wobei das Halbleiterelement (4) auf einer dem Substrat (6) abgewandten Seite eine Kontaktfläche (8) aufweist,
wobei die Kontaktfläche (8) des Halbleiterelements (4) über zumindest ein Verdrahtungselement (22) mit dem Substrat (6) verbunden ist,
wobei das zumindest eine Verdrahtungselement (22)
- einen ersten Verbindungsabschnitt (24), welcher die Kontaktfläche (8) mit einem zweiten Leitungsabschnitt (16) der Substratmetallisierung (14) verbindet, und
- einen zweiten Verbindungsabschnitt (26), welcher die Kontaktfläche (8) mit einem dritten Leitungsabschnitt (18) der Substratmetallisierung (14) verbindet,
aufweist,
wobei der zweite und der dritte Leitungsabschnitt (16, 18) der Substratmetallisierung (14) konfiguriert sind, dass der erste Verbindungsabschnitt (24) und der zweite Verbindungsabschnitt (26) während eines Betriebes der Halbleiteranordnung (2) einen unsymmetrischen Stromfluss aufweisen.

2. Halbleiteranordnung (2) nach Anspruch 1,
wobei der zweite und der dritte Leitungsabschnitt (16, 18) der Substratmetallisierung (14) auf gegenüberliegenden Seiten des Halbleiterelements (4) angeordnet sind.

3. Halbleiteranordnung (2) nach einem der Ansprüche 1 oder 2, wobei ein durch den ersten Verbindungsabschnitt (24) des zumindest einen Verdrahtungselements (22) fließender erster Strom (I1), insbesondere Laststrom, um das Hundertfache, insbesondere um das Tausendfache größer ist als ein durch den zweiten Verbindungsabschnitt (26) des zumindest einen Verdrahtungselements (22) fließender zweiter Strom (I2).

4. Halbleiteranordnung (2) nach einem der vorherigen Ansprüche,
wobei der mit dem zweiten Verbindungsabschnitt (26) des zumindest einen Verdrahtungselements (22) verbundene dritte Leitungsabschnitt (18) leerlaufend auf dem Substrat (6) angeordnet ist.

5. Halbleiteranordnung (2) nach einem der vorherigen Ansprüche,
wobei der erste Verbindungsabschnitt (24) und der zweite Verbindungsabschnitt (26) des zumindest einen Verdrahtungselements (22) im Wesentlichen achsensymmetrisch bezüglich einer Symmetrieachse (30) ausgeführt sind.

6. Halbleiteranordnung (2) nach einem der vorherigen Ansprüche,
wobei das zumindest eine Verdrahtungselement (22) einen dritten Verbindungsabschnitt (46) aufweist, welcher den dritten Leitungsabschnitt (18) der Substratmetallisierung (14) mit einer Kontaktfläche (8) eines weiteren Halbleiterelements (34) verbindet.

7. Halbleiteranordnung (2) nach einem der vorherigen Ansprüche,
wobei die Halbleiteranordnung (2) eine Mehrzahl von Verdrahtungselementen (22) zur Verbindung der Kontaktfläche (8) mit dem zweiten und dem dritten Leitungsabschnitt (16, 18) umfasst.

8. Halbleiteranordnung (2) nach Anspruch 7,
wobei das Halbleiterelement (4) auf einer dem dritten Leitungsabschnitt (18) zugewandten Seite breiter ausgeführt ist als der dritte Leitungsabschnitt (18),
wobei ein Hauptstrompfad (IH) des ersten Leitungsabschnitts (12) beidseitig an dem dritten Leitungsabschnitt (18) vorbei verlaufend ausgebildet ist.

9. Halbleiteranordnung (2) nach Anspruch 8,
wobei der Hauptstrompfad (IH) des ersten Leitungsabschnitts (12) im Wesentlichen symmetrisch an dem dritten Leitungsabschnitt (18) vorbei verlaufend ausgebildet ist.

10. Halbleiteranordnung (2) nach einem der Ansprüche 7 bis 9, wobei mehr Verdrahtungselemente (22) mit dem zweiten Leitungsabschnitt (16) als mit dem dritten Leitungsabschnitt (18) verbunden sind.

11. Halbleiteranordnung (2) nach Anspruch 7,
wobei der dritte Leitungsabschnitt (18) der Substratmetallisierung (14) mindestens zwei voneinander elektrisch isoliert angeordnete Verdrahtungsinseln (42, 44) umfasst, welche leerlaufend auf dem Substrat (6) angeordnet sind,
wobei jeweils zumindest ein Verdrahtungselement (22) über den jeweiligen zweiten Verbindungsabschnitt (26) mit einer der Verdrahtungsinseln (42, 44) des dritten Leitungsabschnitts (18) verbunden ist.

12. Halbleiteranordnung (2) nach Anspruch 11,
wobei zwei Verdrahtungsinseln (42, 44) derartig auf dem Substrat (6) angeordnet sind, dass zwischen den Verdrahtungsinseln (42, 44) ein Hauptstrompfad (IH) verlaufend ausgebildet ist.

13. Halbleiteranordnung (2) nach einem der vorherigen Ansprüche,
wobei das Halbleiterelement (4) als schaltbares Halbleiterelement, insbesondere als Transistor, ausgebildet ist und mit zumindest einem weiteren schaltbaren Halbleiterelement (34) eine Halbbrücke ausbildet.

14. Stromrichter (48) mit mindestens einer Halbleiteranordnung (2) nach einem der vorherigen Ansprüche.

15. Verfahren zur Herstellung einer Halbleiteranordnung (2) nach einem der Ansprüche 1 bis 13,
wobei das Halbleiterelement (4), insbesondere stoffschlüssig, auf dem Substrat (6) verbunden wird,
wobei in einem weiteren Schritt die Kontaktfläche (8) des Halbleiterelements (4) über das zumindest eine Verdrahtungselement (22) mit dem Substrat (6) verbunden wird.

16. Computerprogrammprodukt, umfassend Befehle, die bei einer Ausführung des Programms durch einen Computer diesen veranlassen, ein, insbesondere thermisches, mechanisches und/oder elektrisches, Verhalten einer Halbleiteranordnung (2) nach einem der Ansprüche 1 bis 13 zu simulieren.
